(19) Europäisches Patentamt
European Patent Office
Office européen des brevets

(11) **EP 1 840 978 A1**

(12) **EUROPEAN PATENT APPLICATION**
published in accordance with Art. 158(3) EPC

(43) Date of publication:
**03.10.2007 Bulletin 2007/40**

(51) Int Cl.:
***H01L 33/00*** (2006.01)   ***H01S 5/343*** (2006.01)

(21) Application number: **06711830.7**

(22) Date of filing: **17.01.2006**

(86) International application number:
**PCT/JP2006/300550**

(87) International publication number:
**WO 2006/075759 (20.07.2006 Gazette 2006/29)**

(84) Designated Contracting States:
**DE FR GB**

(30) Priority: **17.01.2005 JP 2005009242**

(71) Applicant: **Anritsu Corporation**
**Atsugi-shi**
**Kanagawa 243-8555 (JP)**

(72) Inventors:
• **SUZUKI, Tetsuya, c/o Int. Prop. Prom. Dept**
**Kanagawa, 243-8555 (JP)**
• **YOSHIDAYA, Hiroaki, c/o Int. Prop. Prom. Dept**
**Kanagawa, 243-8555 (JP)**
• **MURAKAMI, Kiyokazu, c/o Int. Prop. Prom. Dept**
**Kanagawa, 243-8555 (JP)**

(74) Representative: **Balsters, Robert et al**
**Novagraaf International S.A.**
**25, avenue du Pailly**
**1220 Les Avanchets - Geneva (CH)**

(54) **SEMICONDUCTOR OPTICAL ELEMENT HAVING WIDE LIGHT SPECTRUM EMISSION CHARACTERISTICS, METHOD FOR FABRICATING THE SAME, AND EXTERNAL RESONATOR TYPE SEMICONDUCTOR LASER**

(57)     A semiconductor optical device has a semiconductor substrate, and an active layer which is formed above the semiconductor substrate, the active layer having a plurality of quantum wells formed from a plurality of barrier layers and a plurality of well layers sandwiched among the plurality of barrier layers. At least one well layer of the plurality of well layers is formed from an $In_{xa}Ga_{(1-xa)}As$ film, and a composition ratio xa of the In takes any one value within a range from approximately 0.05 to approximately 0.20. Accordingly, the semiconductor optical device is formed as a strained well layer in which lattice distortion bought about in the well layer takes any one value within a range from approximately 0.35% to approximately 1.5%, and the strained well layer is formed so as to have a bandgap wavelength different from those of the other well layers. Consequently, the semiconductor optical device is configured capable of representing, as an optical spectral characteristic, a broad optical spectral characteristic whose center wavelength is from approximately 800 nm to approximately 850 nm, and which has a spectral half bandwidth greater than or equal to a predetermined value.

FIG. 1B

**EP 1 840 978 A1**

**Description**

Technical Field

The present invention relates to a semiconductor optical device and a method of manufacturing the same, as well as an external resonator type semiconductor laser using the same, and in particular, to a semiconductor optical device which has a broad optical spectral luminescence characteristic in a semiconductor optical device such as a super luminescent diode as a semiconductor optical device using a compound semiconductor, a semiconductor optical amplifier, or an amplifying element for an external resonator type semiconductor laser, and a method of manufacturing the same, as well as an external resonator type semiconductor laser using the same.

Background Art

In recent years, because a super luminescent diode (SLD), which is realized as a form of semiconductor optical device and used within a wavelength range from approximately 800 nm to approximately 850 nm in center wavelength, has a luminescence characteristic of a predetermined spectral half bandwidth as an optical spectral luminescence characteristic, applications thereof for an optical gyroscope, an optical communication device, an optical application measuring device, and the like have been promoted.

In such an SLD, usually, a III-V compound semiconductor is used in order to obtain the predetermined spectral luminescence characteristic described above.

Then, SLDs are realized by a semiconductor optical device of a structure using pn junction for an active layer, a semiconductor optical device of a structure using quantum wells formed from a plurality of barrier layers and a plurality of well layers, or the like.

By the way, a semiconductor optical amplifier (SOA) and an amplifying element for an external resonator type semiconductor laser which are realized as semiconductor optical devices having functions different from the above-described SLDs have luminescence characteristic of a predetermined spectral half bandwidth as an optical spectral luminescence characteristic thereof in the same manner as the SLD described above.

In contrast thereto, a luminescence characteristic that light is emitted at a predetermined wavelength is required for a semiconductor laser.

Then, a semiconductor laser configured as described hereinafter has been known as a semiconductor laser for improving the luminescence characteristic.

Namely, with respect to the semiconductor laser, InGaAs is usually used as a material of well layers configuring an active layer, and a thicknesses of the well layers (a width of quantum wells) is selected from a range of 6 to 10 nm as a semiconductor laser which has a semiconductor substrate made of GaAs and which emits light within a wavelength range of 870 to 1100 nm (for example, refer to Patent Document 1 described below).

Further, in this semiconductor laser, in order to bring about desired lattice distortion in the well layers made of InGaAs for the purpose of emitting light favorably at a predetermined wavelength required, a composition rate of In in the InGaAs is determined (for example, refer to Patent Document 1 described below).

Note that, in the field of semiconductor lasers, a technology of semiconductor laser for emitting light at a wavelength range of 780 nm has also been disclosed in which $In_{0.03}Ga_{0.97}As$ is used as the material of well layers configuring an active layer, and a thicknesses of the well layers (a width of quantum wells) is 3 nm (for example, refer to Patent Document 2 described below).

Further, in an SOA to be used within a wavelength range of 800 to 870 nm, GaAs is used as the well layers, and generally, the thicknesses of the well layers are made greater than or equal to 5 nm from the viewpoint that a predetermined luminescence characteristic is ensured (for example, refer to Patent Document 2 described below).

By the way, the above-described SLD is required to emit light at an emission spectral half bandwidth broader than the luminescence characteristic of the semiconductor laser from the viewpoint of usage.

An example of a method of broadening an emission spectrum of a semiconductor optical device includes a method in which a plurality of well layers having different emission wavelength ranges are provided in an active layer (for example, refer to Patent Documents 3 and 4 described below).

However, because operations as an light emitting element within an overall range of driving current are easily made unstable due to problems as follows in a semiconductor optical device having such a structure according to a prior art, it is difficult to maintain a predetermined emission spectral half bandwidth.

Namely, this is because there is the problem in the semiconductor optical devices according to the prior art that, for example, there are many light emitting elements which operate such that a bandwidth with high intensity moves to a short wavelength side or spreads to a short wavelength side as driving current increases in contrast to the fact that an emission spectrum having high intensity is obtained at a long wavelength side of an emission wavelength range at a low driving current side.

In addition, this is because there is the problem in the semiconductor optical device according to the prior art that a range of driving current which can be used at a desired emission spectral half bandwidth is narrow due to the problem described above.

The same problems have been brought about with respect to an SOA having a predetermined spectral half bandwidth, an amplifying element for an external resonator type semiconductor laser, and the like.

Patent Document 1: Jpn. Pat. Appln. KOKAI Publication No. 05-226789

Patent Document 2: Jpn. Pat. Appln. KOKAI Publication No. 05-175598

Patent Document 3: Jpn. Pat. Appln. KOKAI Publication No. 01-179488

Patent Document 4: Jpn. Pat. Appln. KOKAI Publication No. 57-109387

Disclosure of Invention

In the semiconductor optical devices according to the prior art which are disclosed in the respective Patent Documents as described above, a GaAs film or InGaAs film having thickness of 6 nm or more is used as well layers in an active layer.

However, in such a semiconductor optical device according to the prior art, there is the problem, from the standpoint of using it at an emission wavelength range close to 800 to 850 nm, that it is difficult to stably obtain efficient light emission while maintaining a predetermined emission spectral half bandwidth.

Note that, in the semiconductor laser disclosed in Patent Document 2, the well layer thickness is 3 nm, and the emission wavelength range is 780 nm.

As long as $In_{xa}Ga_{(1-xa)}$ As is used as the well layers due to the restriction in wavelength, such narrow well layers must be used, and $In_{0.03}Ga_{0.97}As$ in which a ratio of In is extremely low is used as the well layers.

Therefore, in this semiconductor layer, there is the problem that the advantage depending on lattice distortion as described above cannot be sufficiently brought out because it is difficult to bring about lattice distortion in the well layers as disclosed in Patent Document 1.

In order to solve the problems of the prior art as described above, an object of the present invention is to provide a semiconductor optical device having a broad optical spectral luminescence characteristic in which a more preferable luminescence characteristic or amplifying characteristic than a semiconductor optical device such as an SLD, an SOA, or an amplifying element for an external resonator type semiconductor laser according to the prior art can be obtained even if a thickness of a well layer is less than or equal to 6 nm, by being configured capable of representing a broad optical spectral luminescence characteristic whose center wavelength is from approximately 800 nm to approximately 850 nm, and which has a spectral half bandwidth greater than or equal to a predetermined value, and to provide a method of manufacturing the same as well as an external resonator type semiconductor laser using the same.

In order to achieve the above object, according to a first aspect of the present invention, there is provided a semiconductor optical device comprising:

a semiconductor substrate (1); and
an active layer (3) which is formed above the semiconductor substrate (1), the active layer having a plurality of quantum wells (3c1, 3c2, ...) formed from a plurality of barrier layers (3a1, 3a2, ...) and a plurality of well layers (3b1, 3b2, ...) sandwiched among the plurality of barrier layers, wherein
at least one well layer of the plurality of well layers is formed from an $In_{xa}Ga_{(1-xa)}As$ film, and a composition ratio xa of the In takes any one value within a range from approximately 0.05 to approximately 0.20, whereby said at least one well layer is formed as a strained well layer in which lattice distortion bought about in the well layer takes any one value within a range from approximately 0.35% to approximately 1.5%, and
due to the strained well layer being formed so as to have a bandgap wavelength different from those of the other well layers,
the semiconductor optical device is configured capable of representing, as an optical spectral characteristic, a broad optical spectral characteristic whose center wavelength is from approximately 800 nm to approximately 850 nm, and which has a spectral half bandwidth greater than or equal to a predetermined value.

According to this configuration, the active layer has a strained well layer having a bandgap wavelength different from those of the other quantum wells, this strained well layer is formed from an $In_{xa}Ga_{(1-xa)}As$ film, and a composition ratio xa of In takes any one value within a range from approximately 0.05 to approximately 0.20, whereby lattice distortion brought about in the strained well layer takes any one value within a range from approximately 0.35% to approximately 1.5%. Consequently, it is possible to bring about lattice distortion to the extent of realizing a luminescence characteristic based on lattice distortion. Accordingly, it is possible to realize a semiconductor optical device which can stably obtain a more preferable luminescence characteristic than that of a semiconductor optical device such as an SLD, an SOA, or an amplifying element for an external resonator type semiconductor laser according to the prior art even if a thickness of the well layer is less than 6 nm.

In order to achieve the above object, according to a second aspect of the present invention, there is provided the semiconductor optical device according to the first aspect, wherein the strained well layer has any one layer thickness within a range from approximately 2.5 nm to approximately 5 nm.

According to this configuration, in addition to the advantage according to the first aspect, desired lattice distortion can be effectively brought about because at least one strained well layer has any one layer thickness within a range from approximately 2.5 nm to approximately 5 nm. Consequently, it is possible to realize a semiconductor optical device which can stably obtain a further more preferable luminescence characteristic or amplifying characteristic within a wavelength range whose center wavelength is from approximately 800 nm to approximately 850 nm as compared with a semiconductor optical device according to the prior art.

In order to achieve the above object, according to a third aspect of the present invention, there is provided the semiconductor optical device according to the first aspect, wherein the plurality of quantum wells included in the active layer respectively have substantially identical layer thickness.

According to this configuration, in addition to the advantage according to the first aspect, the respective quantum wells included in the active layer have substantially identical layer thickness. Therefore, it is possible to realize a semiconductor optical device which can bring about lattice distortion in at least one strained well layer appropriately at a center wavelength within the above-described wavelength range and with a well layer thickness.

In order to achieve the above object, according to a fourth aspect of the present invention, there is provided the semiconductor optical device according to the first aspect, wherein the semiconductor optical device is applied as a super luminescent diode (SLD) (100).

In order to achieve the above object, according to a fifth aspect of the present invention, there is provided the semiconductor optical device according to the first aspect, wherein the semiconductor optical device is applied as a semiconductor optical amplifier (SOA) (200).

In order to achieve the above object, according to a sixth aspect of the present invention, there is provided the semiconductor optical device according to the first aspect, wherein the semiconductor optical device is applied as an amplifying element for an external resonator type semiconductor laser (300).

In order to achieve the above object, according to a seventh aspect of the present invention, there is provided the semiconductor optical device according to the first aspect, wherein an n-GaAs substrate is used as the semiconductor substrate (1).

In order to achieve the above object, according to an eighth aspect of the present invention, there is provided the semiconductor optical device according to the fourth aspect, wherein

the SLD (100) comprises, as the semiconductor optical device: a first cladding layer (2) formed above a surface of the semiconductor substrate (1); the active layer (3) formed above the first cladding layer (2); a second cladding layer (4) formed above the active layer (3); an etching blocking layer (5) formed in the second cladding layer (4); a contact layer (6) formed above the second cladding layer (4); an insulating film (7) formed above the contact layer (6) and above the etching blocking layer (5); a first electrode (8) formed above the insulating film (7); and a second electrode (9) formed on a rear face of the semiconductor substrate (1), and

has:

a ridge portion (10) which serves as a gain region, the ridge portion being formed in a trapezoidal shape above the etching blocking layer (5) at a central portion of the semiconductor optical device in a shorter direction, and in a stripe form above the etching blocking layer (5) at a position from one facet to a vicinity of a central portion of the semiconductor optical device in a longitudinal direction of the semiconductor optical device;

an absorption region (11) which absorbs light and electric current, the absorption region being formed in a stripe form in an inside of the semiconductor optical device including the active layer (3) at a position adjacent to the ridge portion (10) from a vicinity of the central portion to another facet of the semiconductor optical device in the longitudinal direction of the semiconductor optical device;

regions to which light is not guided, the regions being formed at positions facing both side portions of the ridge portion (10); and

an antireflection coating (12) which is formed at one facet in the longitudinal direction of the semiconductor optical device.

In order to achieve the above object, according to a ninth aspect of the present invention, there is provided the semiconductor optical device according to the fifth aspect, wherein

the SOA (200) comprises, as the semiconductor optical device: a first cladding layer (202) formed above a surface of the semiconductor substrate (201); the active layer (203) formed above the first cladding layer (202); a second cladding layer (204) formed above the active layer (203); an etching blocking layer (205) formed in the second cladding layer (204); a contact layer (206) formed above the second cladding layer (204); an insulating film (207) formed above the contact layer (206); a first electrode (208) formed above the insulating film (207); and a second electrode (209) formed on a rear face of the semiconductor substrate (201), and

has: a gain region formed above the etching blocking layer (205); first and second antireflection coatings (212, 213) into and from which light is incident and emitted, the first and second antireflection coatings being formed on both facets of the semiconductor optical device; and first and second current non-injection regions (214, 215) formed in vicinities of both facets of the gain region.

In order to achieve the above object, according to a tenth aspect of the present invention, there is provided a method of manufacturing a semiconductor optical device, comprising:

a step of sequentially depositing a first cladding layer (2) made of an n-$Al_{xb}Ga_{(1-xb)}$As layer, an active layer (3) including a plurality of well layers (3B1, 3B2, ...) made of undoped $In_{xa}Ga_{(1-xa)}$As and a plurality of barrier layers (3a1, 3a2, ...) made of undoped $Al_{xc}Ga_{(1-xc)}$As, a second cladding layer (4) made of a p-$Al_{xb}Ga_{(1-xb)}$As layer, an etching blocking layer (5) in the second cladding layer (4), and a contact layer (6) made of p$^+$-GaAs, above a (100) plane of a semiconductor substrate (1) made of n-GaAs;

a step of forming a ridge isolation resist pattern ($R_1$) to isolate a ridge portion (10) and a non-waveguide portion (20) on the contact layer (6);

a step of forming isolation grooves which isolate the ridge portion (10) and the non-waveguide portion (20) by removing portions of the second cladding layer (4) and the contact layer (6) at a side further toward a surface than the etching blocking layer (5) with the ridge isolation resist pattern ($R_1$) being as an etching mask;

a step of forming an insulating film (7) after the isolation grooves are formed;

a step of forming a contact hole forming resist pattern ($R_2$) to form a contact hole by removing apportion of the insulating film (7) above the ridge portion (10);

a step of removing a portion of the insulating film (7) above the ridge portion (10) after a contact hole is formed with the contact hole forming resist pattern ($R_2$) being as an etching mask;

a step of forming a p-electrode (8) from the surface side of the semiconductor substrate (1) after the contact hole is formed;

a step of making the semiconductor substrate (1) be a predetermined thickness by grinding a rear face of the semiconductor substrate (1) after the p-electrode (8) is formed; and

a step of forming an n-electrode (9) on the rear face of the semiconductor substrate (1) after the semiconductor substrate (1) is grinded so as to be a predetermined thickness, wherein

at least one well layer of the plurality of well layers is formed from an $In_{xa}Ga_{(1-xa)}$As film, and a composition ratio xa of the In takes any one value within a range from approximately 0.05 to approximately 0.20, whereby the at least one well layer is formed as a strained well layer in which lattice distortion takes any one value within a range from approximately 0.35% to approximately 1.5%, and

due to the strained well layer being formed so as to have a bandgap wavelength different from those of the other well layers,

the semiconductor optical device is configured capable of representing, as an optical spectral characteristic, a broad optical spectral characteristic whose center wavelength is from approximately 800 nm to approximately 850 nm, and which has a spectral half bandwidth greater than or equal to a predetermined value.

In order to achieve the above object, according to an eleventh aspect of the present invention, there is provided an external resonator type semiconductor laser comprising:

a semiconductor optical device (400) which emits light within a predetermined wavelength range; and

an external resonator (500) which receives the light within a predetermined wavelength range emitted from the semiconductor optical device (400), and which selects a light of a predetermined wavelength to be returned to the semiconductor optical device, wherein

the semiconductor optical device (400) comprises:

a semiconductor substrate (201); and

an active layer (203) which is formed above the semiconductor substrate (201), the active layer having a plurality of quantum wells formed from a plurality of barrier layers and a plurality of well layers sandwiched among the plurality of barrier layers,

at least one well layer of the plurality of well layers is formed from an $In_{xa}Ga_{(1-xa)}$As film, and a composition ratio xa of the In takes any one value within a range from approximately 0.05 to approximately 0.20, whereby the at least one well layer is formed as a strained well layer in which lattice distortion bought about in the well layer takes any one value within a range from approximately 0.35% to approximately 1.5%, and
due to the strained well layer being formed so as to have a bandgap wavelength different from those of the other well layers,
the semiconductor optical device is configured capable of representing, as an optical spectral characteristic, a broad optical spectral characteristic whose center wavelength is from approximately 800 nm to approximately 850 nm, and which has a spectral half bandwidth greater than or equal to a predetermined value, and
the external resonator (500) comprises:

wavelength selection means (502) for receiving the light within a predetermined wavelength range emitted from the semiconductor optical device (400), and selecting a light of a predetermined wavelength; and optical means (501), which is provided between the semiconductor optical device (400) and the wavelength selection means (502), for causing the light within a predetermined wavelength range selected by the wavelength selection means (502) to be incident into the wavelength selection means (502), and returning the light of a predetermined wavelength selected by the wavelength selection means (502) to the semiconductor optical device (400).

In order to achieve the above object, according to a twelfth aspect of the present invention, there is provided the external resonator type semiconductor laser according to the eleventh aspect, wherein the wavelength selection means (502) of the external resonator (500) is configured by a diffraction grating at which a wavelength of a reflected light is selectable by changing an angle of reflection.

In order to achieve the above object, according to a thirteenth aspect of the present invention, there is provided the external resonator type semiconductor laser according to the eleventh aspect, wherein the wavelength selection means (502) of the external resonator (500) is configured by a wavelength tunable filter (503) and a total reflection mirror (504).

In order to achieve the above object, according to a fourteenth aspect of the present invention, there is provided the external resonator type semiconductor laser according to the eleventh aspect, wherein the strained well layer of the semiconductor optical device (100) has any one layer thickness within a range from approximately 2.5 nm to approximately 5 nm.

In order to achieve the above object, according to a fifteenth aspect of the present invention, there is provided the external resonator type semiconductor laser according to the eleventh aspect, wherein the plurality of quantum wells included in the active layer (3) of the semiconductor optical device (100) respectively have substantially identical layer thickness.

In order to achieve the above object, according to a sixteenth aspect of the present invention, there is provided the external resonator type semiconductor laser according to the eleventh aspect, wherein an n-GaAs substrate is used as the semiconductor substrate (1).

In order to achieve the above object, according to a seventeenth aspect of the present invention, there is provided the external resonator type semiconductor laser according to the eleventh aspect, wherein the semiconductor optical device (400) comprises:

a first cladding layer (202) formed above a surface of the semiconductor substrate (201); the active layer (203) formed above the first cladding layer and having the plurality of quantum wells formed from the plurality of barrier layers and the plurality of well layers sandwiched among the plurality of barrier layers; a second cladding layer (204) formed above the active layer (203); an etching blocking layer (205) formed in the second cladding layer (204); a contact layer (206) formed above the second cladding layer (204); an insulating film (207) formed above the contact layer (206); a first electrode (208) formed above the insulating film (207) on the contact layer (206); and a second electrode (209) formed on a rear face of the semiconductor substrate (201), and
has: a gain region formed above the etching blocking layer (205); first and second antireflection coatings (212, 213) into and from which light is incident and emitted, the first and second antireflection coatings being formed on both facets; and first and second current non-injection regions (214, 215) formed in vicinities of both facets of the gain region.

The semiconductor optical device according to the present invention comprises an active layer (3, 203) formed above a semiconductor substrate (1, 201) and having a plurality of quantum wells formed from a plurality of barrier layers and a plurality of well layers sandwiched among the plurality of barrier layers, wherein, at least one well layer of the plurality of well layers is formed from an $In_{xa}Ga_{(1-xa)}$ As film, and a composition ratio xa of the In takes any one value within a range from approximately 0.05 to approximately 0.20, whereby the at least one well layer is formed as a strained well layer in which lattice distortion bought about in the well layer takes any one value within a range from approximately 0.35% to approximately 1.5%. In addition, due to the strained well layer being formed so as to have a bandgap wavelength different from those of other well layers, the semiconductor optical device is configured capable of representing, as an optical spectral luminescence characteristic, a broad optical spectral luminescence characteristic whose center wavelength is from approximately 800 nm to approximately 850 nm, and which has a spectral half bandwidth greater than or equal to a predetermined value.

According to the present invention, the active layer has at least one strained well layer having a bandgap wavelength different from those of the other well layers, the strained well layer is formed from an $In_{xa}Ga_{(1-xa)}As$ film, and a composition ratio xa of the In takes any one value within a range from approximately 0.05 to approximately 0.20, whereby lattice distortion bought about in the well layer takes any one value within a range from approximately 0.35% to approximately 1.5%. Therefore, the semiconductor optical device is configured such that it is possible to brought about lattice distortion to the extent of realizing a luminescence characteristic based on lattice distortion, and it is capable of representing, as an optical spectral characteristic, a broad optical spectral luminescence characteristic whose center wavelength is from approximately 800 nm to approximately 850 nm, and which has a spectral half bandwidth greater than or equal to a predetermined value. Accordingly, it is possible to provide a semiconductor optical device having a broad optical spectral luminescence characteristic in which a more preferable luminescence characteristic or amplifying characteristic than that of a semiconductor optical device according to the prior art can be stably obtained even if a thickness of the well layer is less than 6 nm, and to provide a method of manufacturing the same as well as an external resonator type semiconductor laser using the same.

Brief Description of Drawings

FIG. 1A is a plan view shown for explaining a configuration of an SLD to which a semiconductor optical device according to a first embodiment of the present invention is applied.

FIG. 1B is a cross-sectional view taken along line 1B-1B of FIG. 1A.

FIG. 2A is a characteristic diagram showing one example of a relationship between film thicknesses of well layers configuring an active layer and emission wavelengths with composition ratios of In serving as parameters for explanation of a principle of the SLD shown in FIGS. 1A and 1B.

FIG. 2B is a characteristic diagram showing another example of the relationship between film thicknesses of well layers configuring an active layer and emission wavelengths with composition ratios of In serving as parameters for explanation of a principle of the SLD shown in FIGS. 1A and 1B.

FIG. 3A is a diagram shown for explaining one example of a structure of the active layer of the SLD shown in FIGS. 1A and 1B.

FIG. 3B is a diagram shown for explaining another example of the structure of the active layer of the SLD shown in FIGS. 1A and 1B.

FIG. 4A is a process view shown for explaining a method of manufacturing the SLD shown in FIGS. 1A, 1B and 3A.

FIG. 4B is a process view shown for explaining the method of manufacturing the SLD shown in FIGS. 1A, 1B and 3A.

FIG. 4C is a process view shown for explaining the method of manufacturing the SLD shown in FIGS. 1A, 1B and 3A.

FIG. 4D is a process view shown for explaining the method of manufacturing the SLD shown in FIGS. 1A, 1B and 3A.

FIG. 5A is a process view shown for explaining the method of manufacturing the SLD shown in FIGS. 1A, 1B and 3A.

FIG. 5B is a process view shown for explaining the method of manufacturing the SLD shown in FIGS. 1A, 1B and 3A.

FIG. 5C is a process view shown for explaining the method of manufacturing the SLD shown in FIGS. 1A, 1B and 3A.

FIG. 6A is a diagram showing one example of an emission spectrum obtained by the SLD shown in FIGS. 1A, 1B and 3A.

FIG. 6B is a characteristic diagram showing another example of the emission spectrum obtained by the SLD shown in FIGS. 1A, 1B and 3B, and a relationship between driving current and output power (shown by the solid line) in comparison with those (shown by the broken line) of an SLD according to a prior art.

FIG. 7A is a plan view shown for explaining a configuration of a semiconductor optical amplifier to which a semiconductor optical device according to a second embodiment of the present invention is applied.

FIG. 7B is a cross-sectional view taken along line 7B-7B of FIG. 7A.

FIG. 8 is a block diagram shown for explaining a configuration of an external resonator type semiconductor laser according to a third embodiment of the present invention.

FIG. 9 is a block diagram shown for explaining another configuration of the external resonator type semiconductor laser according to the third embodiment of the present invention.

Best Mode for Carrying Out the Invention

Hereinafter, several embodiments of the present invention will be described with reference to the drawings.

(First Embodiment)

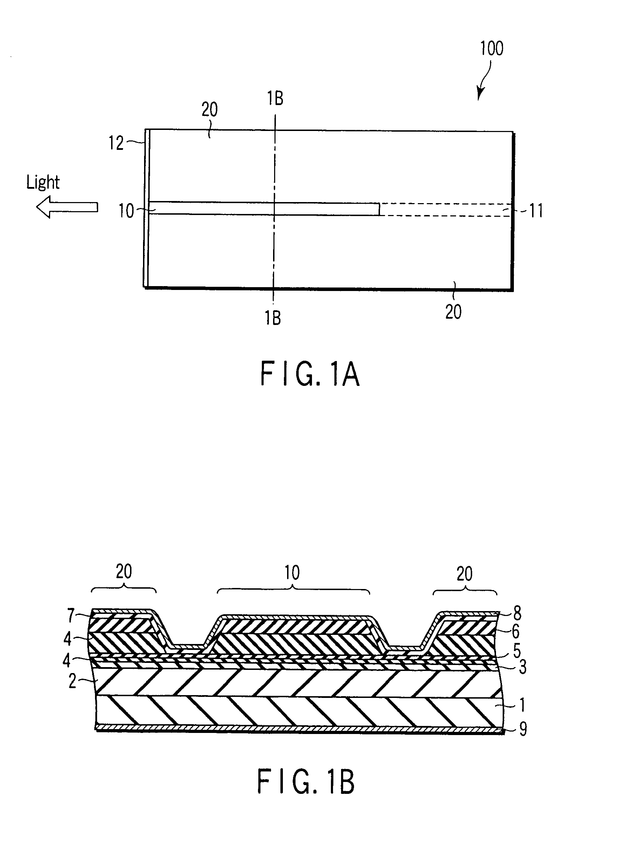

FIGS. 1A and 1B show a basic structure of a super luminescent diode (SLD) to which a semiconductor optical device according to a fist embodiment of the present invention is applied.

Namely, FIG. 1A is a plan view shown for explaining a configuration of an SLD 100 to which the semiconductor optical device according to the fist embodiment of the invention is applied.

In addition, FIG. 1B is a cross-sectional view taken along line 1B-1B of the SLD 100 shown in FIG. 1A.

First, as shown in FIG. 1B, the SLD 100 has a first cladding layer 2 formed above the surface of a semiconductor substrate 1, an active layer 3 formed above the first cladding layer 2, a second cladding layer 4 formed above the active layer 3, an etching blocking layer 5 formed in the second cladding layer 4, a contact layer 6 formed above the second cladding layer 4, an insulating film 7 formed above the contact layer 6 and above the etching blocking layer 5, a first electrode 8 formed above the insulating film 7, and a second electrode 9 formed on the rear face of the semiconductor substrate 1 (the overside of the substrate surface onto which the respective semiconductor layers 2, 3, 4, and 5 have been sequentially deposited).

Then, in FIG. 1A, a portion denoted by reference numeral 10 is a ridge portion which serves as a gain region which is formed in a trapezoidal shape above the etching blocking layer 5 at a central portion of the device in a shorter direction of the device, and in a stripe form above the etching blocking layer 5 at a position from one facet to the vicinity of a central portion of the device in a longitudinal direction of the device.

Further, a portion denoted by reference numeral 11 is an absorption region for light and electric current which is formed in a stripe form in the inside of the device including the active layer 3 at a position adjacent to the ridge portion 10 from the vicinity of the central portion to the another facet of the device in the longitudinal direction of the device.

Furthermore, portions denoted by reference numeral 20 are regions which are formed at positions facing to the both side portions of the ridge portion 10 and to which light is not guided (hereinafter referred to as a non-waveguide portion), namely, regions into which operating currents are not injected because the second cladding layer 4 of the portions is not connected to the ridge portion 10.

A film denoted by reference numeral 12 is an antireflection coating formed at the one facet of the semiconductor optical device in the longitudinal direction of the device.

In addition, because the SLD 100 to which the semiconductor optical device according to the first embodiment of the invention is applied is, as will be described later, configured capable of representing a broad optical spectral characteristic whose center wavelength is from approximately 800 nm to approximately 850 nm, and which has a spectral half bandwidth greater than or equal to a predetermined value, the SLD 100 is used within an emission wavelength range from approximately 800 nm to approximately 850 nm.

First, the semiconductor substrate 1 used for the SLD 100 is an n-GaAs substrate.

As a material of the semiconductor substrate 1, a III-V semiconductor can be used.

However, with respect to a GaAs substrate, the combination with the active layer 3 formed on the substrate is favorable, a high-quality substrate can be obtained, the solid state property thereof is comparatively known, such a substrate is easy to obtain, and the like. For this reason, a GaAs substrate is favorably used as a material of the semiconductor substrate 1.

Note that, because an electron mobility is higher than an electron hole mobility in GaAs, an n-GaAs substrate has lower resistivity than that of a p-GaAs substrate.

In the SLD 100, a distance from the active layer 3 to the electrode 9 on the rear face of the semiconductor substrate 1 is longer than a distance to the electrode 8 on the contact layer 6. Thus, an n-GaAs substrate is used as the semiconductor substrate 1 in order to prevent an electric resistance from the electrode 9 on the rear face of the semiconductor substrate 1 to the active layer 3 from being made larger.

Further, the first cladding layer 2 used for the SLD 100 is formed from an $n$-$Al_{xb}Ga_{(1-xb)}$As layer.

In this case, because a difference in lattice constant between $n$-$Al_{xb}Ga_{(1-xb)}$As and n-GaAs used as the semiconductor substrate 1 is small, the problem of defect associated with lattice mismatch can be prevented, and therefore, $n$-$Al_{xb}Ga_{(1-xb)}$As is favorable as the first cladding layer 2 formed above the semiconductor substrate 1.

A composition ratio xb of Al of the $n$-$Al_{xb}Ga_{(1-xb)}$AS used as the first cladding layer 2 is approximately 0.4, a high impurity concentration thereof is approximately $1 \times 10^{18}$ cm$^{-3}$, a layer thickness thereof is approximately 2 $\mu$m, and for example, Si is favorable as n-type impurity.

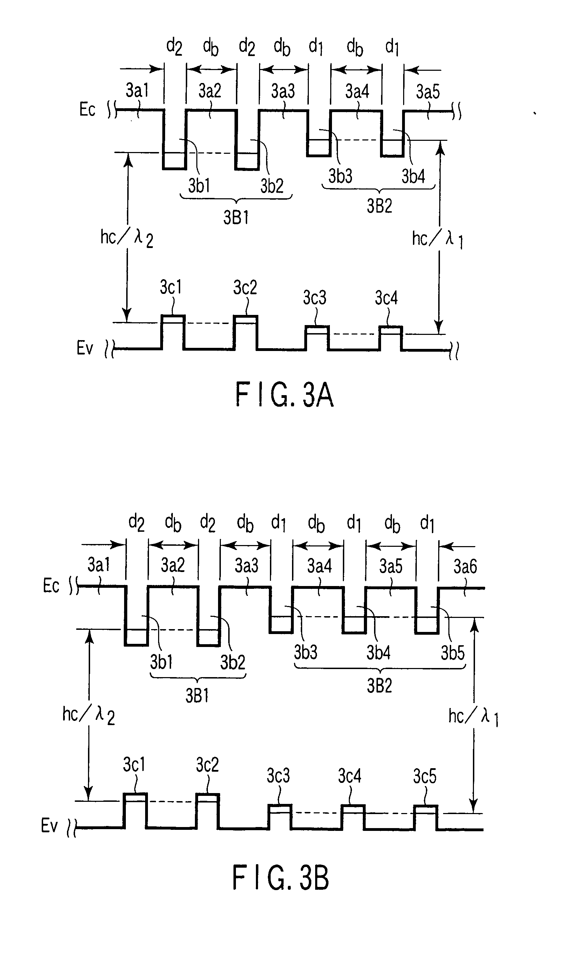

The active layer 3 used for the SLD 100 has, as shown in FIGS. 3A and 3B described later, a plurality of quantum wells 3c1, 3c2, ... formed from a plurality of barrier layers 3a1, 3a2, ..., and a plurality of well layers 3b1, 3b2, ... formed so as to be sandwiched among the plurality of barrier layers 3a1, 3a2, ....

Then, the plurality of well layers 3b1, 3b2, ... are respectively formed by using undoped $In_{xa}Ga_{(1-xa)}As$.

Further, the plurality of barrier layers 3a1, 3a2, ... are respectively formed by using undoped $Al_{xc}Ga_{(1-xc)}As$.

Here, $In_{xa}Ga_{(1-xa)}As$ used for the plurality of well layers 3b1, 3b2, ... can improve the luminous quantum efficiency as the SLD 100 by bringing about lattice distortion in the well layers. For this reason, $In_{xa}Ga_{(1-xa)}As$ is used for forming at least one strained well layer among the plurality of well layers 3b1, 3b2, ... configuring the active layer 3.

In this case, at least the one strained well layer, as will be described later, has a bandgap wavelength different from those of the other quantum wells, and a composition ratio xa of the In in the undoped $In_{xa}Ga_{(1-xa)}As$ used for the well layer takes any one value within a range from approximately 0.05 to approximately 0.20, and therefore, lattice distortion brought about in the strained well layer takes any one value within a range from approximately 0.35% to approximately 1.5%. As a consequence, it is possible to bring about lattice distortion to the extent of favorably realizing a luminescence characteristic based on lattice distortion.

Here, a relationship between a composition ratio xa of In in the undoped $In_{xa}Ga_{(1-xa)}As$ used for a well layer and an amount of lattice distortion s brought about in the strained well layer will be described.

The amount of lattice distortion s brought about in the strained well layer made of $In_{xa}Ga_{(1-xa)}As$ is calculated as a lattice constant with respect to a GaAs substrate in accordance with the following formulas.

```
s =

[{a(InGaAs)-a(GaAs)}/a(GaAs)] × 100%      ... (1)
```

provided that,

```
a(InGaAs)

= a(GaAs) × (1-xa) + a(InAs) × xa          ... (2)
```

Here, a(InGaAs) is a lattice constant of $In_{xa}Ga_{(1-xa)}As$, and xa is a composition ratio of In in III group elements.

Further, a(GaAs) is a lattice constant of GaAs, and a(GaAs) = 0.56533 (nm).

Furthermore, a(InAs) is a lattice constant of InAs, and a(InAs) = 0.60584 (nm).

Accordingly, when the composition ratio xa of In used in the present invention is 0.05 which is the lower limit, the following formula is obtained given that a (GaAs) = 0.56533 (nm) and a(InAs) = 0.60584 (nm) are substituted for formula (2).

```
a(InGaAs)

= 0.56533 (nm) × (1-0.05) + 0.60584 (nm) × 0.05

= 0.5370635 (nm) + 0.329200 (nm)

= 0.5673655 (nm)
```

Next, given that a (InGaAs) = 0.5673655 (nm) and a (GaAs) = 0.56533 (nm) are substituted for formula (1), the following formula is obtained.

```
s = [{0.5673655 (nm) - 0.56533 (nm)}/0.56533 (nm)]

 × 100%

= {0.0020355 (nm)/0.56533 (nm)} × 100%

= 0.3600551%
```

Accordingly, in the present invention, the amount of lattice distortion s when the composition ratio xa of In is 0.05 which is the lower limit is approximately 0.35%.

Further, when the composition ratio xa of In used in the present invention is 0.20 which is the upper limit, the following formula is obtained given that a (GaAs) = 0.56533 (nm) and a (InAs) = 0.60584 (nm) are substituted for formula (2).

$$
\begin{aligned}
a(InGaAs) \\
&= 0.56533 \ (nm) \times (1-0.20) + 0.60584 \ (nm) \times 0.20 \\
&= 0.452264 \ (nm) + 0.121168 \ (nm) \\
&= 0.573432 \ (nm)
\end{aligned}
$$

Next, given that a(InGaAs) = 0.573432 (nm) and a (GaAs) = 0.56533 (nm) are substituted for formula (1), the following formula is obtained.

$$
\begin{aligned}
s &= [\{0.573432 \ (nm) - 0.56533 \ (nm)\}/0.56533 \ (nm)] \\
&\quad \times 100\% \\
&= \{0.008102 \ (nm)/0.56533 \ (nm)\} \times 100\% \\
&= 1.4331452\%
\end{aligned}
$$

Consequently, in the present invention, the amount of lattice distortion s when the composition ratio xa of In is 0.20 which is the upper limit is approximately 1.5%.

As described above, the SLD 100 according to the embodiment is, as will be described later, configured capable of representing, as an optical spectral luminescence characteristic thereof, a broad optical spectral luminescence characteristic whose center wavelength is from approximately 800 nm to approximately 850 nm, and which has a spectral half bandwidth greater than or equal to a predetermined value, and to stably obtain high optical gain.

In one example shown in FIG. 3A, the plurality of well layers 3b1, 3b2, ... are formed from two types, i.e., first and second types, and a composition ratio xa of In of the first type well layer (hereinafter, the first well layer 3B1) is 0.10 while a composition ratio xa of In of the second type well layer (hereinafter, the second well layer 3B2) is 0.02, and all the thicknesses $d_2$ of those are made to be approximately 3 nm.

Here, the respective types of well layers may be respectively plural layers, and the well layers are made to be in two layers in the one example shown here.

Further, all composition ratios Xc of Al of $Al_{xc}Ga_{(1-xc)}As$ used for the plurality of barrier layers 3a1, 3a2, ... are approximately 0.25.

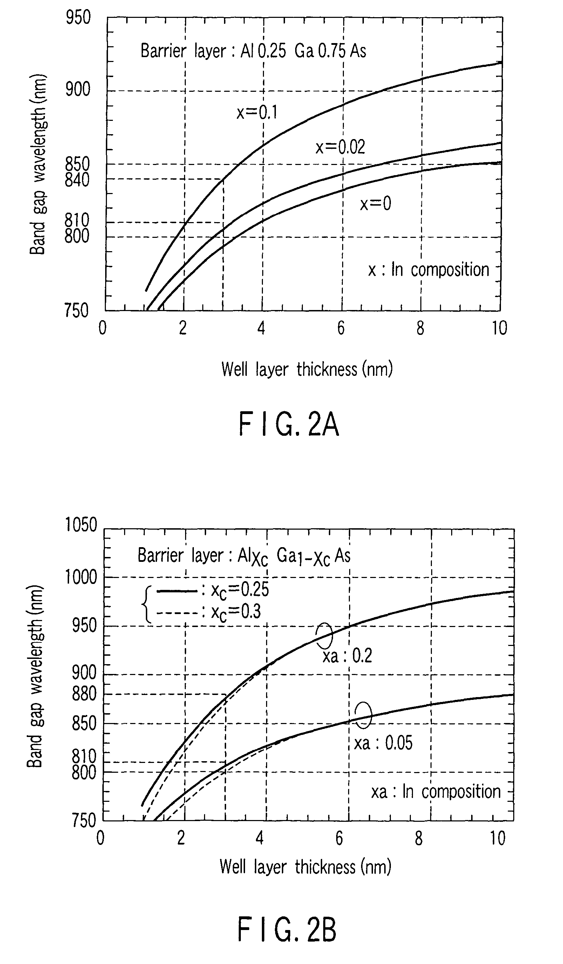

FIG. 2A is a characteristic diagram showing a relationship between film thicknesses d (nm) of the well layers and bandgap (emission) wavelengths $\lambda$ (nm) according to the above-described one example with composition ratios Xa of In serving as parameters.

As shown in FIG. 2A, a bandgap wavelength is approximately 840 nm when a composition ratio xa of In in the undoped $In_{xa}Ga_{(1-xa)}As$ used as the respective well layers is approximately 0.10, and in the same manner, a bandgap wavelength is approximately 810 nm when the composition ratio xa of In is approximately 0.02.

FIG. 2B is a characteristic diagram showing a relationship between film thicknesses d (nm) of the well layers and bandgap (emission) wavelengths $\lambda$ (nm) according to another example with composition ratios Xa of In serving as parameters.

As shown in FIG. 2B, a bandgap wavelength is approximately 880 nm when a composition ratio xa of In in the undoped $In_{xa}Ga_{(1-xa)}As$ used for the respective well layers is approximately 0.20, and in the same manner, a bandgap wavelength is approximately 810 nm when the composition ratio xa of In is approximately 0.05.

Note that, in FIG. 2B, the characteristics shown by the solid lines are obtained in the case where a composition ratio xc of Al in the barrier layer $Al_{xc}Ga_{(1-xc)}As$ is 0.25.

Further, in FIG. 2B, the characteristics shown by the broken lines are obtained in the case where the composition ratio xc of Al in the barrier layer $Al_{xc}Ga_{(1-xc)}As$ is 0.3.

FIG. 3A is a diagram for explanation of a structure of the active layer 3 according to the one example shown in FIG. 2A.

Namely, the active layer 3 has the plurality of barrier layers 3a1, 3a2, ..., and the plurality of well layers 3b1, 3b2, ... formed so as to be sandwiched among the plurality of barrier layers 3a1, 3a2, ..., whose types are two types, and the first well layer 3B1 and the second well layer 3B2 serving as the respective types of well layers are respectively formed from the two layers 3b1 and 3b2, and 3b3 and 3b4.

In FIG. 3A, Ec denotes a bottom energy level of a conduction band, and Ev denotes a top energy level of a valence band.

Further, in FIG. 3A, symbol h is a Planck's constant, and symbol c denotes a velocity of light.

Here, the second well layer 3B2 has a thickness d of $d_1$, and is designed to emit light of a bandgap wavelength $\lambda_1$ (approximately 840 nm).

Further, the first well layer 3B1 has a thickness d of $d_2$, and is designed to emit light of a bandgap wavelength $\lambda_2$ (approximately 810 nm).

As shown in FIG. 3A described above, $d_1$ and $d_2$ serving as the thicknesses of the respective well layers are approximately 3 nm which are identical.

In addition, all thicknesses $d_b$ of the respective barrier layers 3a1, 3a2, ... are 10 nm which are identical.

FIG. 3B is a diagram for explanation of a structure of the active layer 3 according to another example shown in FIG. 2B described above.

Namely, the active layer 3 has the plurality of barrier layers 3a1, 3a2, ..., and the plurality of well layers 3b1, 3b2, ... formed so as to be sandwiched among the plurality of barrier layers 3a1, 3a2, ..., whose types are two types, and the first well layer 3B1 and the second well layer 3B2 serving as the respective types of well layers are respectively formed from the two layers 3b1 and 3b2, and the three layers 3b3, 3b4, and 3b5.

In FIG. 3B, Ec denotes a bottom energy level of a conduction band, and Ev denotes a top energy level of a valence band.

Further, in FIG. 3B, symbol h is a Planck's constant, and symbol c denotes a velocity of light.

Here, the second well layer 3B2 has a thickness d of $d_1$, and is designed to emit light of a bandgap wavelength $\lambda_1$ (approximately 880 nm).

Further, the first well layer 3B1 has a thickness d of $d_2$, and is designed to emit light of a bandgap wavelength $\lambda_2$ (approximately 810 nm).

As shown in FIG. 3B described above, $d_1$ and $d_2$ serving as the thicknesses d of the respective well layers are approximately 3 nm which are identical.

In addition, all thicknesses $d_b$ of the respective barrier layers 3a1, 3a2, ... are approximately 10 nm which are identical.

Next, to return FIG. 1, the second cladding layer 4 used for the SLD 100 is formed from a $p-Al_{xb}Ga_{(1-xb)}As$ layer, and a high impurity concentration thereof is approximately $1 \times 10^{18}$ cm$^{-3}$ and a layer thickness thereof is approximately 2 $\mu$m.

Note that the etching blocking layer 5 provided in the second cladding layer 4 is made of InGaP, and a layer thickness thereof is approximately 15 nm.

Further, the contact layer 6 used for the SLD 100 is formed from a $p^+$-GaAs layer, and a high impurity concentration thereof is approximately $1 \times 10^{19}$ cm$^{-3}$ and a layer thickness thereof is approximately 1 $\mu$m.

In this case, a preferable example of a p-type impurity of the $p^+$-GaAs layer used as the contact layer 6 includes Zn.

Note that suppose that the electrode (hereinafter referred to as p-electrode) 8 above the contact layer 6, and the contact layer 6 are electrically connected via contact holes provided at the insulating film 7 made of $SiO_2$.

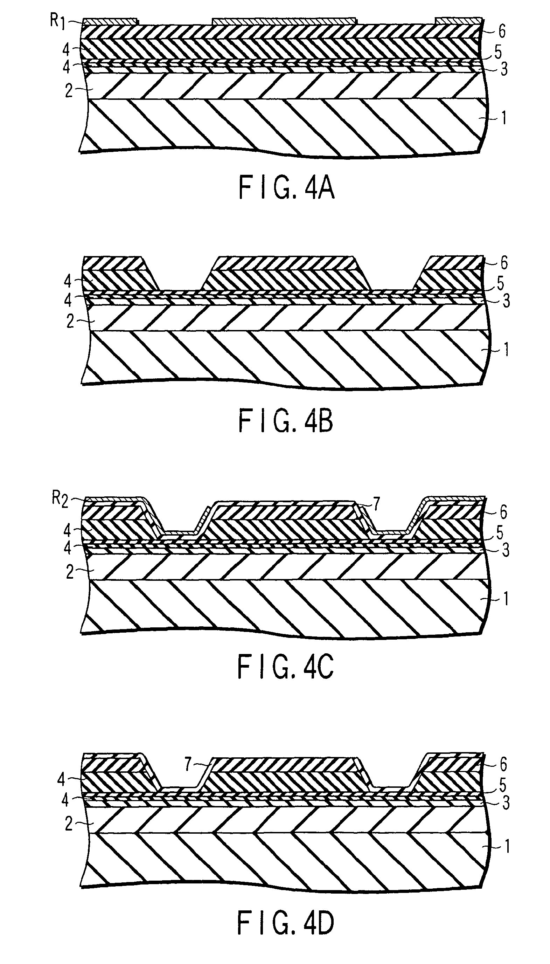

Hereinafter, a method of manufacturing the SLD 100 according to the first embodiment of the present invention will be described with reference to FIGS. 4A to 5C.

First, as shown in FIG. 4A, the first cladding layer 2 made of an $n-Al_{xb}Ga_{(1-xb)}$ As layer, the active layer 3 including a plurality of quantum wells configured by a plurality of well layers made of undoped $In_{xa}Ga_{(1-xa)}As$ and a plurality of barrier layers made of undoped $Al_{xc}Ga_{(1-xc)}As$, the second cladding layer 4 formed from a $p- Al_{xb}Ga_{(1-xb)}As$ layer, and the contact layer 6 made of $p^+$-GaAs are sequentially deposited above a (100) plane of the semiconductor substrate 1 made of n-GaAs (process 1).

Here, the etching blocking layer 5 made of p-InGaP is provided at a position in the second cladding layer 4 closer to the active layer 3.

The respective semiconductor layers 2, 3, 4, 5, and 6 may be deposited by using, for example, a technology of MOVPE (Metal Organic Vapor Phase Epitaxy), and may be formed by using another technology.

Further, for example, Si or the like is used as an n-type impurity in the respective semiconductor layers 2, 4, 5 and 6, and for example, Zn or the like is used as a p-type impurity.

However, applications of respective impurities in the present invention are not limited to these elements, and may be other elements.

The thicknesses of the respective semiconductor layers 2, 4, 5 and 6 are, for example, about 2 $\mu$m, 2 $\mu$m, 15 nm, and 1 $\mu$m respectively from the semiconductor substrate 1 side.

Note that the active layer 3 has the configuration of the layers described above, i.e., has the plurality of quantum wells 3c1, 3c2, ... formed from the plurality of barrier layers 3a1, 3a2, ..., and the plurality of well layers 3b1, 3b2, ... sandwiched among the plurality of barrier layers 3a1, 3a2, ....

Namely, at least one well layer of the plurality of well layers 3b1, 3b2, ... configuring the active layer 3 is formed as a strained well layer in which a composition ratio Xa of In in undoped $In_{xa}Ga_{(1-xa)}As$ used for it takes any one value within a range from approximately 0.05 to approximately 0.20. As a consequence, as described above, lattice distortion brought about in the strained well layer takes any one value within a range from approximately 0.35% to approximately 1.5%.

Further, the high impurity concentrations in the respective semiconductor layers 2, 4, 5 and 6 are, for example, about $1 \times 10^{18}$ cm$^{-3}$, $1 \times 10^{18}$ cm$^{-3}$, $1 \times 10^{18}$ cm$^{-3}$, and $1 \times 10^{19}$ cm$^{-3}$, respectively, from the semiconductor substrate 1 side.

Note that, in the above description, the thicknesses of the plurality of well layers 3b1, 3b2, ... configuring the active layer 3 are respectively made to be 3 nm. However, applications of the present invention are not limited to the above-described thicknesses of the well layers, and may be any thickness within a range from approximately 2.5 nm to approximately 5 nm.

Hereinafter, the reasons for these numerical limitations will be described.

As described in the item of "Background Art" described above, in a semiconductor optical device used within a wavelength range close to 800 nm to 850 nm, GaAs films having a thickness of about 6 to 10 nm or AlGaAs films having a composition ratio of Al of several % are conventionally used as the well layers in the active layer.

Further, as the barrier layers in the active layer, AlGaAs films having a composition ratio of Al of about 0.2 to 0.3 are used from the viewpoint that an optical confinement factor and efficiency in carrier injection into the quantum wells are maintained to be high.

Namely, in the semiconductor optical device according to the prior art, an attempt is made to realize a semiconductor optical device excellent in luminous efficiency in such a manner that the active layer is configured by use of the well layers and the barrier layers.

On the other hand, by using an InGaAs film as a well layer, compression strain (lattice distortion) can be brought about in the well layer. In GaAs, it is possible to push away a band having a larger effective mass in a direction parallel to the interface of the well layer among two bands degenerated at the valence band ends, to a relatively higher level by energy viewed from a hole (hereinafter referred to as band isolation).

As a result, a band having a smaller effective mass, i.e., a band having a smaller state density can be made to be a band in the ground state of hole. Accordingly, it has been known that, in a quantum well using a InGaAs film as a well layer, a quasi-Fermi level in a valence band can be made higher at a small density of injected carrier by compression strain (lattice distortion) brought about in the well layer, and a satisfactory luminescence characteristic can be obtained.

However, in the semiconductor optical device according to the prior art, as described above, it is actually difficult to stably obtain efficient light emission or amplification while maintaining a predetermined spectral half bandwidth from the viewpoint of utilizing it at a bandwidth close to 800 nm to 850 nm.

This is because, for example, in the example of a semiconductor laser in the above-described Patent Document 2, whose center wavelength is positioned in a region of shorter wavelength than approximately 800 nm, an InGaAs film having a composition ratio of In of about 0.03 is used as the active layer, so that a composition ratio of In is low, and the effect of band isolation described above due to compression strain (lattice distortion) cannot be sufficiently desired.

In advance of the explanation of this reason, an explanation will be given with respect to the lower limit (approximately 2.5 nm) of the thicknesses of the plurality of well layers 3b1, 3b2, ... configuring the active layer 3 in the semiconductor optical device of the present invention, and the upper limit (approximately 0.20) of the composition ratio of In of the $In_{xa}Ga_{(1-xa)}As$ films used for the plurality of well layers 3b1, 3b2, ....

First, as the well layers are made to be thinner, fluctuation in thickness of the well layer at the atomic layer level gradually becomes problematic.

Such a thickness of the well layer that fluctuation in thickness at the atomic layer level starts to become problematic is about 2.5 nm.

Accordingly, in the semiconductor optical device of the present invention, the lower limit of the well layer of InGaAs is made to be approximately 2.5 nm, and the thickness of the well layer is made to be approximately 2.5 nm or more in order for fluctuation in thickness at the atomic layer level not to become problematic.

Further, as the composition ratio of In in the well layer is made to be greater, high-quality crystal cannot be obtained due to lattice mismatch between the well layer and the GaAs substrate or the like.

Such a composition ratio of In by which crystallinity starts to become problematic is about 0.20.

Accordingly, in the semiconductor optical device of the present invention, the upper limit of the composition ratio of In in the well layer is made to be approximately 0.20, and the composition ratio of In in the well layer is made to be approximately 0.20 or less.

Here, to return the explanation of the reason that the effect of the band isolation described above cannot be sufficiently desired.

For example, if the composition ratio of In in the well layer is made to be 0.03, and the composition ratio of Al in the AlGaAs barrier layer is made to be 0.3, an energy difference between a heavy hole and a light hole due to compression strain (lattice distortion) becomes 13 to 14 meV.

Because this energy difference is about half as much as 25.9 meV which is energy at a room temperature (kT, where T is an absolute temperature of 300K, and k is a Boltzmann constant), it is impossible to sufficiently ensure the holes at a ground level so as to be against thermal fluctuation due to an energy difference of 13 to 14 meV.

In this way, in the semiconductor optical device according to the prior art, the configuration of the well layers is not made preferably, such as the fact that a composition ratio of In in a well layer is 0.03 which is low. Therefore, it is actually impossible to obtain high optical gain with a well layer thickness of 5 nm or less.

In contrast thereto, in the present invention, the composition is made such that the composition ratios of In in the plurality of well layers configuring the active layer 3 are made to be approximately 0.05 or more at minimum, i.e., an energy difference of about 22 to 23 meV or more can be obtained, which makes it possible to sufficiently ensure the holes at a ground level so as to be against thermal fluctuation.

In this case, the above-described conditions can be favorably satisfied by using InGaAs films as the plurality of well layers configuring the active layer 3, and by making a composition ratio of In in a well layer at the long wavelength side (in the cases of FIGS. 2A and 3A described above, $\lambda_1$: approximately 840 nm) higher than a composition ratio of In in a well layer at the short wavelength side (in the cases of FIGS. 2A and 3A described above, $\lambda_2$: approximately 810 nm) within a range up to approximately 0.20.

Namely, in the present invention in which the plurality of quantum wells with different bandgaps are used as the active layers, it is possible to broaden an emission spectral width as the SLD 100 by providing intensive compression strain (lattice distortion) to a quantum well having a longer bandgap wavelength among the plurality of quantum wells.

The reason for this is as follows. That is, because the quasi-Fermi levels throughout the plurality of quantum wells in a state in which the device is operating are at identical level, gain of quantum wells with a short wavelength bandgap is added to optical gain of the quantum wells with a long wavelength bandgap having intensive compression strain (lattice distortion) by leaving quasi-Fermi level intervals of the quantum wells whose bandgap wavelength are short, as described above, so as to follow the quasi-Fermi level intervals of the quantum wells having intensive compression strain (lattice distortion) which can broaden the quasi-Fermi level intervals at conductive band and valence band from a low injected current, so that a wavelength spectrum can be broadened as a whole device.

Further, in the present invention, because there is the operation that In atoms capture contamination by using InGaAs films as the plurality of well layers configuring the active layer 3, it is possible to obtain the effect that the crystallinity of the well layers can be improved.

Here, in the present invention, if the composition ratio of In of the InGaAs films used as the plurality of well layers configuring the active layer 3 is made to be approximately 0.05 serving as the lower limit, the thickness thereof is made to be approximately 2.5 nm serving as the lower limit, and the composition ratio of Al of the AlGaAs barrier layers is made to be 0.3, a bandgap wavelength is made to be approximately 800 nm (to be exact, 797 nm).

In the case of the configuration similar to the above-described configuration, in which the composition ratio of In of the well layers is made to be approximately 0.05 serving as the lower limit, and the thickness thereof is made to be approximately 5 nm serving as the upper limit, a bandgap wavelength is made to be approximately 850 nm (to be exact, 857.8 nm).

Further, in the case of the configuration similar to the above-described configuration, in which the thickness of the well layer is made to be approximately 2.5 nm serving as the lower limit, and the composition ratio of In thereof is made to be approximately 0.20 serving as the upper limit, a bandgap wavelength is made to be approximately 850 nm (to be exact, 862 nm).

As described above, in the present invention, the composition ratio of In of InGaAs films used as the plurality of well layers configuring the active layer 3 is made to be approximately 0.05 to approximately 0.20, and the thickness thereof is made to be approximately 2.5 nm to approximately 5 nm. Consequently, as described above, the effect of lattice distortion from approximately 0.35% to 1.35% which is brought about in the well layers can be effectively utilized, so that it is possible to realize quantum wells in which a broad spectral half bandwidth and high optical gain can be stably obtained within a wavelength range from approximately 800 to approximately 850 nm.

Note that applications of the present invention are not limited to the layer thicknesses and the high impurity concentrations of the respective semiconductor layers 2, 4, 5 and 6, and those may be other layer thicknesses and high impurity concentrations.

Next, processings after the respective semiconductor layers 2, 4, 5 and 6 are formed will be described.

First, as shown in FIG. 4A, a resist pattern for isolating the ridge portion 10 and the non-waveguide portions 20 (hereinafter referred to as a ridge isolation resist pattern) $R_1$ is formed by using a photolithography technique or the like.

Here, suppose that the longitudinal direction of the ridge portion 10 is directed to the [011] axial direction (process 2).

After the ridge isolation resist pattern $R_1$ is formed in process 2, the semiconductor films (the second cladding layer 4 and the contact layer 6) which are further toward the surface side than the etching blocking layer 5 are eliminated by etching with the ridge isolation resist pattern $R_1$ being as an etching mask by use of a sulfuric acid-hydrogen peroxide solution system etchant, whereby isolation grooves for isolating the ridge portion 10 and the non-waveguide portions 20 are formed (process 3, refer to FIG. 4B).

Note that suppose that the ridge isolation resist pattern $R_1$ is removed after the isolation grooves are formed in process 3.

After the isolation grooves are formed in process 3, the insulating film 7 made of $SiO_2$ is formed by using a method such as an electron cyclotron resonance (ECR), a chemical vapour deposition (CVD), or the like (process 4, refer to FIG. 4C).

After the insulating film 7 made of $SiO_2$ is formed in process 4, the $SiO_2$ film on the ridge portion 10 is removed by using a photolithography technique or the like, whereby a resist pattern for forming contact hole (hereinafter referred to as a contact hole forming resist pattern) $R_2$ is formed (process 5, refer to FIG. 4C).

After the contact hole forming resist pattern $R_2$ is formed in process 5, the $SiO_2$ film on the ridge portion 10 is removed by etching by use of a hydrofluoric acid system etchant, whereby a contact hole is formed (process 6, refer to FIG. 4D).

Suppose that, in process 6, the contact hole forming resist pattern $R_2$ is removed after the contact hole is formed.

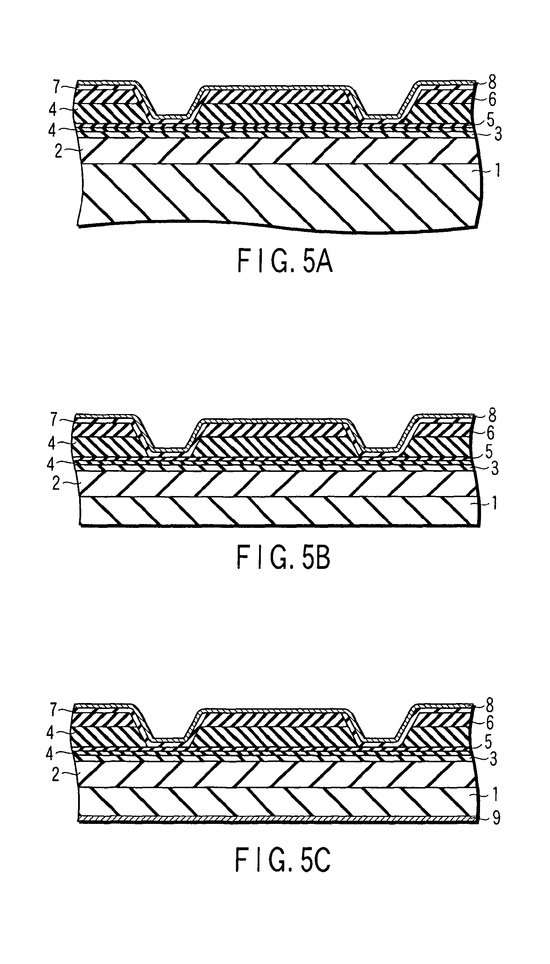

After the contact hole is formed in process 6, the p-electrode 8 is formed by depositing metal for forming the p-electrode (the first electrode) 8 from the surface side of the semiconductor substrate 1 (process 7, refer to FIG. 5A).

After the p-electrode 8 is formed in process 7, the semiconductor substrate 1 is made to have a predetermined thickness by grinding the rear face of the semiconductor substrate 1 (process 8, refer to FIG. 5B).

After the semiconductor substrate 1 is grinded so as to be the predetermined thickness, the n-electrode (second electrode) 9 is formed at the rear face of the semiconductor substrate 1 (process 9, refer to FIG. 5C).

The SLD 100 according to the invention is obtained in accordance with processes 1 to 9 as described above.

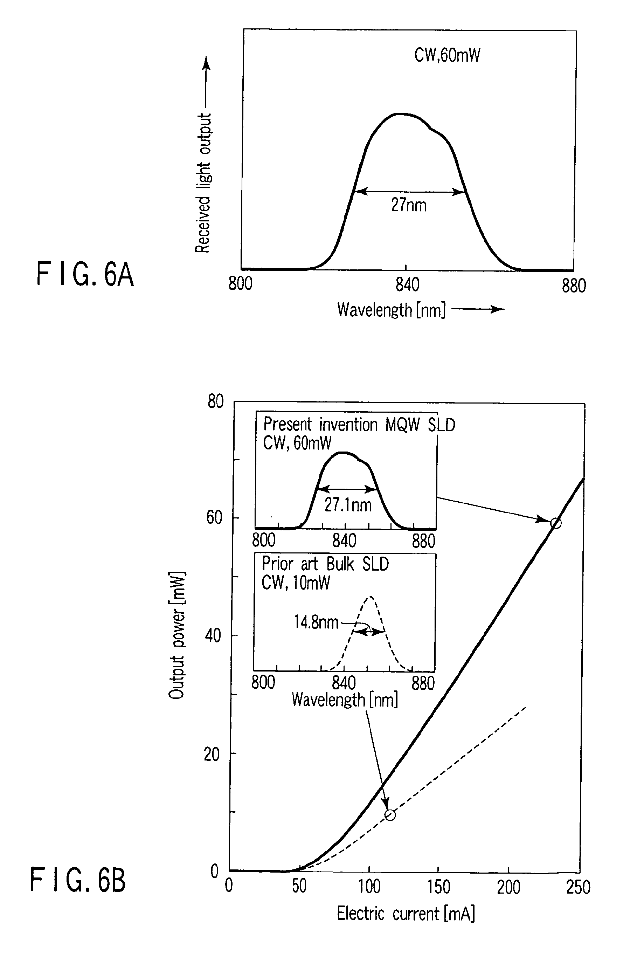

FIG. 6A is a characteristic diagram showing one example of an emission spectrum obtained by the SLD 100 manufactured as described above (however, which corresponds to the configuration of the one example shown in FIG. 3A).

In the example shown in FIG. 6A, continuous light whose output is 60 mW, center wavelength is 840 nm, and spectral half bandwidth is 27 nm is obtained.

Here, since an emission spectrum from the first well layer and an emission spectrum from the second well layer are smoothly coupled, an emission spectrum in a single curve line is formed as shown in the figure.

FIG. 6B is a characteristic diagram showing another example of the emission spectrum obtained by the SLD 100 manufactured as described above (however, which corresponds to the configuration of the other example shown in FIGS. 2B and 3B, and a relationship between driving current and optical output power (shown by the solid line) characteristic in comparison with those (shown by the broken line) of the SLD according to the prior art.

In the characteristic diagram of the other example shown in FIG. 6B, it can be known that, while continuous light whose output is 60 mW, center wavelength is 840 nm, and spectral half bandwidth is 27 nm can be obtained in the case of the SLD 100 according to the invention, continuous light whose output is 10 mW, center wavelength is 850 nm, and spectral half bandwidth is 14.8 nm is merely obtained in the case of the SLD according to the prior art.

Also in the case of the example of the SLD 100 according to the present invention shown in FIG. 6B, an emission spectrum from the first well layer and an emission spectrum from the second well layer are smoothly coupled, and as a consequence, an emission spectrum in a single curve line is formed as shown in the figure.

As described above, the active layer 3 of the SLD 100 according to the present invention is formed from a plurality of InGaAs well layers or the like having compression strain. At least one of these well layers has a bandgap wavelength different from those of the other well layers, and a composition ratio xa of In is made to be within a range from approximately 0.05 to approximately 0.20, which makes lattice mismatch, i.e., compression strain (lattice distortion) with respect to the GaAs substrate be about 0.35% to about 1.5%.

In this way, in the well layer having compression strain (lattice distortion) of about 0.35% to about 1.5%, the density of state of the hole is reduced because the effective mass in the direction of the interface of the well layers of the hole occupying the valence band ends is made lighter.

Namely, in the SLD 100 of the present invention, even in a state in which a density of carrier to be injected into the quantum well having an $In_{xa}GA_{(1-xa)}As$ well layer is little, a quasi-Fermi level of the hole easily goes into the valence band, so that optical gain higher than that of the SLD according to the prior art can be obtained from a region in which electric current flowing therein is little.

Further, in the SLD 100 of the present invention, an energy difference between a ground quantum level and a first excitation level is made greater by making the well layers being thin from approximately 2.5 nm to approximately 5 nm as described above, and thus, the following effects can be obtained.

Namely, by concentrating carriers onto a ground quantum level, optical gain can be further boosted up in a state in which low electric current is injected, and an emission spectral half bandwidth can be broadened in a state in which high electric current is injected.

Note that, when a quantum well having a well layer having a film thickness thinner than the above-described well layer thickness (approximately 2.5 nm to approximately 5 nm) is used, the effects of fluctuation in growth of the well layer thickness at the atomic layer level is made greater, which makes the controllability of wavelength or the like difficult.

The above-described first embodiment has explained the example in which the present invention is applied to the SLD. However, applications of the present invention are not limited to the above-described example, and the present invention can be applied to a semiconductor optical amplifier having a predetermined spectral half bandwidth, a semiconductor optical device such as an amplifying element for an external resonator type semiconductor laser, and the like in the same manner.

(Second Embodiment)

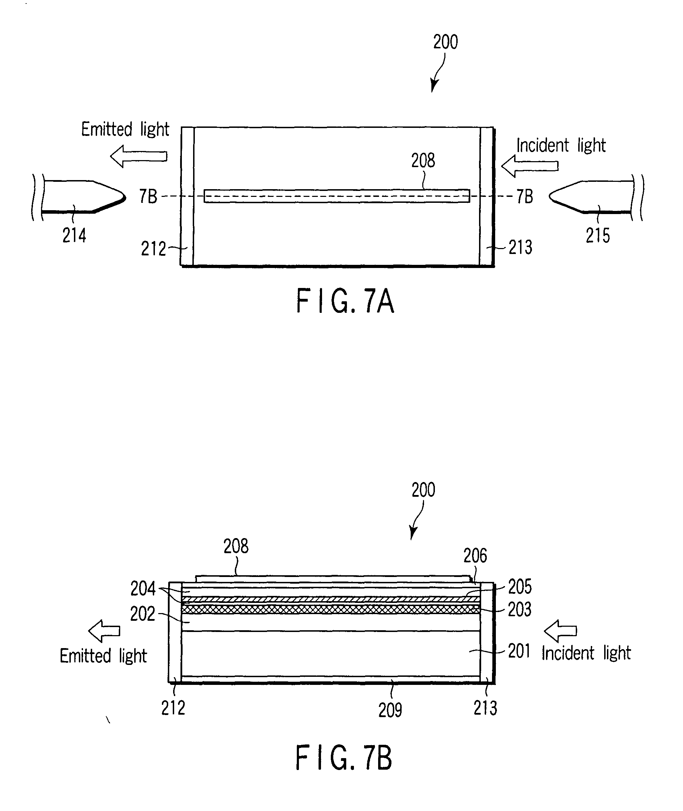

FIGS. 7A and 7B are diagrams showing structures in a case in which a semiconductor optical amplifier is applied as a second embodiment of the semiconductor optical device according to the present invention.

Namely, FIG. 7A is a plan view of a semiconductor optical amplifier 200 which is applied as the second embodiment of the semiconductor optical device according to the present invention.

Further, FIG. 7B is a cross-sectional view taken along line 7B-7B of FIG. 7A.

As shown in FIG. 7B, the semiconductor optical amplifier 200 has, in the same manner as the SLD 100 shown in FIG. 1B, a first cladding layer 202, an active layer 203, a second cladding layer 204, an etching blocking layer 205, a contact layer 206, and an insulating film 207 which are sequentially deposited above the surface of a semiconductor substrate 201, and a p-electrode (first electrode) 208 on the contact layer 206, an n-electrode (second electrode) formed on the rear face of the semiconductor substrate 201 (the overside of the substrate surface onto which the respective semiconductor layers 202 to 205 have been sequentially deposited).

Here, the semiconductor optical amplifier 200 is different from the SLD 100 described above in that absorption regions are not formed, and that antireflection coatings 212 and 213 are formed on the both facets into and from which light is incident and emitted.

Further, by providing a region of about 50 nm in which there is no electrode (a current non-injection region) in the vicinity of the facet of the gain region, a leak current via the facet can be suppressed, and a device having resistance to deterioration in the facet can be manufactured.

Suppose that the active layer 203 has, in the same manner as the active layer 3 of the SLD 100 shown in FIG. 3A or FIG. 3B, the plurality of quantum wells 3c1, 3c2, ... including the plurality of barrier layers 3a1, 3a2, ..., and the plurality of well layers 3b1, 3b2, ... sandwiched among the plurality of barrier layers.

Then, in this semiconductor optical amplifier 200, a driving current is supplied between the p-electrode 208 and the n-electrode 209 from a driving source (not shown). In addition, when a light is made to be incident from the direction shown as "incident light" in FIGS. 7A and 7B, the light is emitted from the direction shown as "emitted light" in FIGS. 7A and 7B as a light which has been coupled to be amplified by passing through the gain region in the semiconductor optical amplifier 200 configured such that the light emits light for itself.

Concretely, light from the exterior can be inputted and outputted via rounded-end optical fibers 214 and 215 which are made to be close to the both facets of the semiconductor optical amplifier 200.

Accordingly, a light can be amplified at predetermined gain between the rounded-end optical fibers 214 and 215 by using the configuration of the semiconductor optical device according to the second embodiment of the present invention as described above, and therefore, the semiconductor optical amplifier 200 having a predetermined amplifying characteristic within a broadband can be realized.

Note that it may be configured such that an incident light from, in place of the rounded-end optical fibers 214 and 215, a usual optical fiber is condensed by using a lens to be incident into the semiconductor optical amplifier 200, and the light amplified in the semiconductor optical amplifier 200 to be outputted is collimated by using a lens to be coupled together with the usual optical fiber.

Further, optical absorption at a facet is suppressed due to a window region being formed by applying processing such as zinc diffusion to the above-described current non-injection region, which can realize further improvement in the characteristics.

Furthermore, the same advantage can be obtained by providing the current non-injection region or the window region described above at the emitting side facet of the semiconductor optical amplifier 200.

Moreover, in the same manner as the semiconductor optical amplifier 200, the SLD may be configured by providing an antireflection coating to the facet opposite to the emitting side facet (hereinafter referred to as the opposed facet) after the absorption regions of the SLD 100 are removed to be all changed into gain regions.

With the configuration, a monitor light can be outputted from the opposed facet to a light-sensitive element (not shown) which is provided at the opposed facet side.

(Third Embodiment)

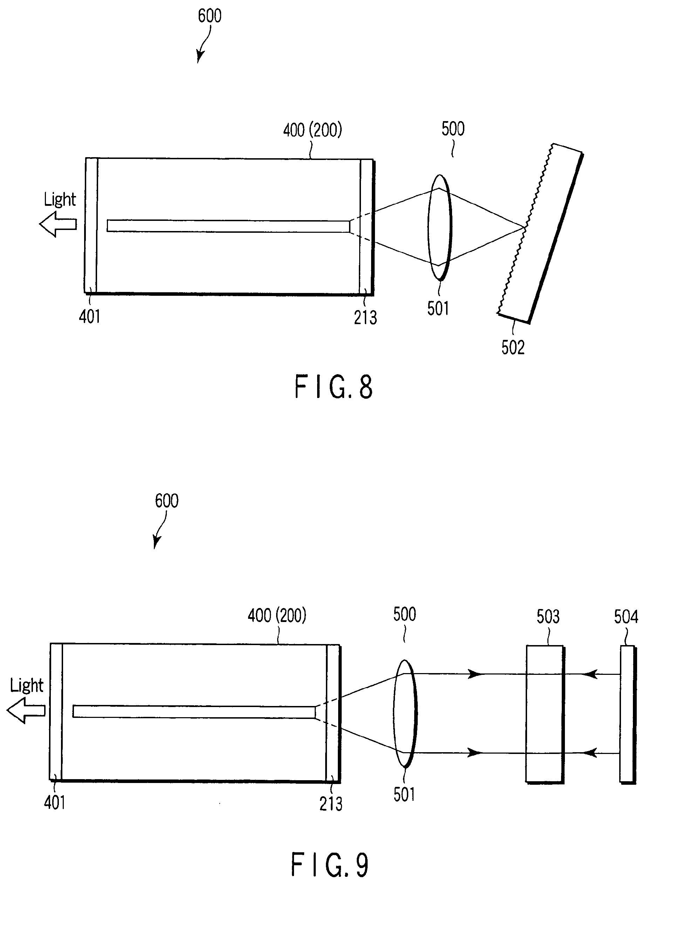

FIG. 8 is a diagram shown for explaining a configuration of an external resonator type semiconductor laser 600 according to a third embodiment of the present invention.

An external resonator type semiconductor laser having a broad wavelength tuning bandwidth can be realized by applying the semiconductor optical device according to the second embodiment of the invention to a semiconductor optical device 400 of the external resonator type semiconductor laser 600.

In this case, the semiconductor optical device 400 is configured to emit light for itself in substantially the same manner as the semiconductor optical amplifier 200 to which the semiconductor optical device according to the second embodiment is applied.

However, in the semiconductor optical device 400, an antireflection coating 401 having a predetermined reflectance is formed at a device facet serving as an optical incident side, in place of the one antireflection coating 212 of the first and second antireflection coatings 212 and 213 which are formed on the both facets of the semiconductor optical amplifier 200.

The external resonator type semiconductor laser 600 according to the third embodiment has an external resonator 500 having a condenser lens 501 which makes an emitted light from the semiconductor optical device 400 be a parallel light, and a diffraction grating 502 serving as wavelength selection means for reflecting only light of a predetermined wavelength among optic elements made to be incident via the condenser lens 501, and for returning the light to the semiconductor optical device 400 side via the condenser lens 501.

Here, as the wavelength selection means, the diffraction grating 502 by which a wavelength of a reflected light can be selected by changing an angle of reflection is usually used.

Namely, the external resonator type semiconductor laser 600 according to the third embodiment has the semiconductor optical device 400 configured to emit light for itself in substantially the same manner as the semiconductor optical amplifier 200 to which the semiconductor optical device according to the second embodiment is applied. As a consequence, an external resonator type semiconductor laser which has a broadband characteristic and has a broad wavelength tuning bandwidth can be realized.

Note that, in place of the diffraction grating 502 used as wavelength selection means, a wavelength tunable filter 503 of a narrow bandwidth using liquid crystal or dielectric multilayer film and a total reflection mirror 504 may be configured to be combined as shown in FIG. 9.

As described above, in accordance with the semiconductor optical device according to the first embodiment of the present invention, the active layer has a strained well layer having an emission center wavelength different from those of the other quantum wells, the strained well layer is formed from a $In_{xa}Ga_{(1-xa)}As$ film, and lattice distortion brought about in the strained well layer takes any one value within a range from approximately 0.35% to approximately 1.5% due to a composition ratio xa of In. Therefore, lattice distortion can be brought about to the extent of realizing an luminescence characteristic based on lattice distortion. Accordingly, even if the thickness of the well layer is less than 6 nm, a luminescence characteristic which is more satisfactory than that of a semiconductor optical device such as an SLD according to the prior art can be obtained.

Further, in accordance with the semiconductor optical device according to the second embodiment of the present invention, the active layer has a strained well layer having an amplifying center wavelength different from those of the other quantum wells, the strained well layer is formed from an $In_{xa}Ga_{(1-xa)}As$ film, and lattice distortion brought about in the strained well layer takes any one value within a range from approximately 0.35% to approximately 1.5% due to a composition ratio xa of In. Therefore, lattice distortion can be brought about to the extent of realizing an amplifying characteristic based on lattice distortion. Accordingly, even if the thickness of the well layer is less than 6 nm, an amplifying characteristic which is more satisfactory than that of a semiconductor optical device such as a semiconductor optical amplifier according to the prior art can be obtained.

Furthermore, in accordance with the external resonator type semiconductor laser according to the third embodiment of the present invention, there are provided the semiconductor optical device 400 configured in substantially the same manner as the semiconductor optical amplifier 200 applied as the semiconductor optical device according to the second embodiment, and the external resonator 500 which receives light within a predetermined wavelength bandwidth emitted from the semiconductor optical device 400, and selects and emits a light of a predetermined wavelength. Consequently, a predetermined luminescence characteristic accompanied with the same operational effects as those of the semiconductor optical amplifier which is applied as the semiconductor optical device according to the second embodiment of the present invention can be exerted.

Moreover, in accordance with the semiconductor optical devices according to the respective embodiments of the present invention, lattice distortion can be effectively brought about because each strained well layer has any one layer thickness within a range from approximately 2.5 nm to approximately 5 nm. As compared with a conventional semiconductor optical device, yet more satisfactory luminescence characteristic or amplifying characteristic can be obtained within a wavelength range whose center wavelength is from approximately 800 nm to 850 nm.

In addition, in accordance with the semiconductor optical devices according to the respective embodiments of the present invention, lattice distortion can be appropriately brought about at a center wavelength within the above-described wavelength range and with the well layer thickness because the respective quantum wells included in the active layer have a substantially same layer thickness.

Accordingly, in accordance with the present invention as described above, it is possible to provide a semiconductor optical device having a broad optical spectral characteristic in which, even if the thicknesses of the well layers of the respective quantum wells included in the active layer are less than 6 nm, it is possible to stably obtain a more preferable luminescence characteristic or amplifying characteristic than that of a semiconductor optical device such as an SLD, a semiconductor optical amplifier, and an amplifying element for an external resonator type semiconductor laser according to the prior art, and to provide a method of manufacturing the same as well as an external resonator type semiconductor laser using the same.

Industrial Applicability

The semiconductor optical device according to the present invention can be applied to applications of an optical gyroscope, an optical communication device, an optical application measuring device, and the like, as a semiconductor optical device having advantages that, even if a thickness of a well layer is less than 6 nm, a more preferable luminescence characteristic or amplifying characteristic than that of a conventional semiconductor optical device can be obtained.

**Claims**

1.   A semiconductor optical device **characterized by** comprising:

a semiconductor substrate; and
an active layer which is formed above the semiconductor substrate, the active layer having a plurality of quantum wells formed from a plurality of barrier layers and a plurality of well layers sandwiched among the plurality of barrier layers, wherein,
at least one well layer of the plurality of well layers is formed from an $In_{xa}Ga_{(1-xa)}As$ film, and a composition ratio xa of the In takes any one value within a range from approximately 0.05 to approximately 0.20, whereby the at least one well layer is formed as a strained well layer in which lattice distortion bought about in the well layer takes any one value within a range from approximately 0.35% to approximately 1.5%, and
due to the strained well layer being formed so as to have a bandgap wavelength different from those of the other well layers,
the semiconductor optical device is configured capable of representing, as an optical spectral characteristic, a broad optical spectral characteristic whose center wavelength is from approximately 800 nm to approximately 850 nm, and which has a spectral half bandwidth greater than or equal to a predetermined value.

2.   The semiconductor optical device according to claim 1, **characterized in that** the strained well layer has any one layer thickness within a range from approximately 2.5 nm to approximately 5 nm.

3.   The semiconductor optical device according to claim 1, **characterized in that** the plurality of quantum wells included in the active layer respectively have substantially identical layer thickness.

4.   The semiconductor optical device according to claim 1, **characterized in that** the semiconductor optical device is applied as a super luminescent diode (SLD).

5.   The semiconductor optical device according to claim 1, **characterized in that** the semiconductor optical device is applied as a semiconductor optical amplifier.

6.   The semiconductor optical device according to claim 1, **characterized in that** the semiconductor optical device is applied as an amplifying element for an external resonator type semiconductor laser.

7. The semiconductor optical device according to claim 1, **characterized in that** an n-GaAs substrate is used as the semiconductor substrate.

8. The semiconductor optical device according to claim 4, **characterized in that**
the SLD comprises, as the semiconductor optical device: a first cladding layer formed above a surface of the semiconductor substrate; the active layer formed above the first cladding layer; a second cladding layer formed above the active layer; an etching blocking layer formed in the second cladding layer; a contact layer formed above the second cladding layer; an insulating film formed above the contact layer and above the etching blocking layer; a first electrode formed above the insulating film; and a second electrode formed on a rear face of the semiconductor substrate, and
has:

a ridge portion which serves as a gain region, the ridge portion being formed in a trapezoidal shape above the etching blocking layer at a central portion of the semiconductor optical device in a shorter direction, and in a stripe form above the etching blocking layer at a position from one facet to a vicinity of a central portion of the semiconductor optical device in a longitudinal direction of the semiconductor optical device;
an absorption region which absorbs light and electric current, the absorption region being formed in a stripe form in an inside of the semiconductor optical device including the active layer at a position adjacent to the ridge portion from a vicinity of the central portion to another facet of the semiconductor optical device in the longitudinal direction of the semiconductor optical device;
regions to which light is not guided, the regions being formed at positions facing both side portions of the ridge portion; and
an antireflection coating which is formed at one facet in the longitudinal direction of the semiconductor optical device.

9. The semiconductor optical device according to claim 5, **characterized in that**
the semiconductor optical amplifier comprises, as the semiconductor optical device: a first cladding layer formed above a surface of the semiconductor substrate; the active layer formed above the first cladding layer; a second cladding layer formed above the active layer; an etching blocking layer formed in the second cladding layer; a contact layer formed above the second cladding layer; an insulating film formed above the contact layer; a first electrode formed above the insulating film; and a second electrode formed on a rear face of the semiconductor substrate, and has: a gain region formed above the etching blocking layer; first and second antireflection coatings into and from which light is incident and emitted, the first and second antireflection coatings being formed on both facets of the semiconductor optical device; and first and second current non-injection regions formed in vicinities of both facets of the gain region.

10. A method of manufacturing a semiconductor optical device, **characterized by** comprising:

a step of sequentially depositing a first cladding layer made of an n-$Al_{xb}Ga_{(1-xb)}$As layer, an active layer including a plurality of well layers made of undoped $In_{xa}Ga_{(1-xa)}$As and a plurality of barrier layers made of undoped $Al_{xc}Ga_{(1-xc)}$As, a second cladding layer made of a p-$Al_{xb}Ga_{(1-xb)}$As layer, an etching blocking layer in the second cladding layer, and a contact layer made of $p^+$-GaAs above a (100) plane of a semiconductor substrate made of n-GaAs;
a step of forming a ridge isolation resist pattern to isolate a ridge portion and a non-waveguide portion on the contact layer;
a step of forming isolation grooves which isolate the ridge portion and the non-waveguide portion by removing portions of the second cladding layer and the contact layer at a side further toward a surface than the etching blocking layer with the ridge isolation resist pattern being as an etching mask;
a step of forming an insulating film after the isolation grooves are formed;
a step of forming a contact hole forming resist pattern to form a contact hole by removing a portion of the insulating film above the ridge portion;
a step of removing a portion of the insulating film above the ridge portion after a contact hole is formed with the contact hole forming resist pattern being as an etching mask;
a step of forming a p-electrode from the surface side of the semiconductor substrate after the contact hole is formed;
a step of making the semiconductor substrate be a predetermined thickness by grinding a rear face of the semiconductor substrate after the p-electrode is formed; and
a step of forming an n-electrode on the rear face of the semiconductor substrate after the semiconductor substrate is grinded so as to be a predetermined thickness, wherein
at least one well layer of the plurality of well layers is formed from an $In_{xa}Ga_{(1-xa)}$ As film, and a composition ratio xa of the In takes any one value within a range from approximately 0.05 to approximately 0.20, whereby the semiconductor optical device is formed as a strained well layer in which lattice distortion takes any one value within a range from approximately 0.35% to approximately 1.5%, and
due to the strained well layer being formed so as to have a bandgap wavelength different from those of the other well layers,
the semiconductor optical device is configured capable of representing, as an optical spectral characteristic, a broad optical spectral characteristic whose center wavelength is from approximately 800 nm to approximately 850 nm, and which has a spectral half bandwidth greater than or equal to a predetermined value.

11. An external resonator type semiconductor laser **characterized by** comprising:

a semiconductor optical device which emits light within a predetermined wavelength range; and
an external resonator which receives the light within a predetermined wavelength range emitted from the semiconductor optical device, and which selects a light of a predetermined wavelength to be returned to the semiconductor optical device, wherein
the semiconductor optical device comprises:

a semiconductor substrate; and
an active layer which is formed above the semiconductor substrate, the active layer having a plurality of quantum wells formed from a plurality of barrier layers and a plurality of well layers sandwiched among the plurality of barrier layers,
at least one well layer of the plurality of well layers is formed from an $In_{xa}Ga_{(1-xa)}$ As film, and a composition ratio xa of the In takes any one value within a range from approximately 0.05 to approximately 0.20, whereby the at least one well layer is formed as a strained well layer in which lattice distortion bought about in the well layer takes any one value within a range from approximately 0.35% to approximately 1.5%, and
due to the strained well layer being formed so as to have a bandgap wavelength different from those of the other well layers,
the semiconductor optical device is configured capable of representing, as an optical spectral characteristic, a broad optical spectral characteristic whose center wavelength is from approximately 800 nm to approximately 850 nm, and which has a spectral half bandwidth greater than or equal to a predetermined value, and
the external resonator comprises:

wavelength selection means for receiving the light within a predetermined wavelength range emitted from the semiconductor optical device, and selecting a light of a predetermined wavelength; and
optical means, which is provided between the semiconductor optical device and the wavelength selection means, for causing the light within a predetermined wavelength range emitted from the semiconductor optical device to be incident into the wavelength selection means, and returning the light of a predetermined wavelength selected by the wavelength selection means to the semiconductor optical device.

12. The external resonator type semiconductor laser according to claim 11, **characterized in that** the wavelength selection means of the external resonator is configured by a diffraction grating at which a wavelength of a reflected light is selectable by changing an angle of reflection.

13. The external resonator type semiconductor laser according to claim 11, **characterized in that** the wavelength selection means of the external resonator is configured by a wavelength tunable filter and a total reflection mirror.

14. The external resonator type semiconductor laser according to claim 11, **characterized in that** the strained well layer of the semiconductor optical device has any one layer thickness within a range from approximately 2.5 nm to approximately 5 nm.

15. The external resonator type semiconductor laser according to claim 11, **characterized in that** the plurality of quantum wells included in the active layer of the semiconductor optical device respectively have substantially identical layer thickness.

16. The external resonator type semiconductor laser according to claim 11, **characterized in that** an n-GaAs substrate is used as the semiconductor substrate of the semiconductor optical device.

17. The external resonator type semiconductor laser according to claim 11, **characterized in that**
the semiconductor optical device comprises:

a first cladding layer formed above a surface of the semiconductor substrate, the active layer formed above the first cladding layer, a second cladding layer formed above the active layer, an etching blocking layer formed in the second cladding layer, a contact layer formed above the second cladding layer, an insulating film formed above the contact layer, a first electrode formed above the insulating film on the contact layer, and a second electrode formed on a rear face of the semiconductor substrate, and
the semiconductor optical device has: a gain region formed above the etching blocking layer; first and second antireflection coatings into and from which light is incident and emitted, the first and second antireflection coatings being formed on both facets; and first and second current non-injection regions formed in vicinities of both facets of the gain region.

100

20

12

1B

Light

10 —— —— 11

1B

20

## FIG. 1A

20                    10                    20

7
4
4
2

8
6
5
3

1
9

## FIG. 1B

F I G. 2A

F I G. 2B

FIG. 3A

FIG. 3B

F I G. 4A

F I G. 4B

F I G. 4C

F I G. 4D

F I G. 5A

F I G. 5B

F I G. 5C

F I G. 6A

F I G. 6B

200

Emitted light

208

Incident light

7B — — — — — — — — — — — — — — — — 7B

214

212

213

215

# FIG. 7A

200

208

206

204

205

202

203

Emitted light

201 Incident light

212

209

213

# FIG. 7B

F I G. 8

F I G. 9

## INTERNATIONAL SEARCH REPORT

| | International application No. |
|---|---|
| | PCT/JP2006/300550 |

**A. CLASSIFICATION OF SUBJECT MATTER**
*H01L33/00*(2006.01), *H01S5/343*(2006.01)

According to International Patent Classification (IPC) or to both national classification and IPC

**B. FIELDS SEARCHED**

Minimum documentation searched (classification system followed by classification symbols)
*H01L33/00*(2006.01), *H01S5/00-5/50*(2006.01)

Documentation searched other than minimum documentation to the extent that such documents are included in the fields searched
Jitsuyo Shinan Koho        1922-1996   Jitsuyo Shinan Toroku Koho   1996-2006
Kokai Jitsuyo Shinan Koho   1971-2006   Toroku Jitsuyo Shinan Koho   1994-2006

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 11-8442 A  (Canon Inc.),<br>12 January, 1999 (12.01.99),<br>Par. Nos. [0062] to [0083], [0089] to [0211];<br>Figs. 7 to 11, 15 to 38<br>& US 6288410 B          & EP 834972 A2 | 1-17 |
| A | JP 2002-76432 A  (Stanley Electric Co., Ltd.),<br>15 March, 2002 (15.03.02),<br>Par. Nos. [0012] to [0032]; Fig. 1<br>& US 2002/0024052 A1 | 1-17 |
| A | JP 2004-95838 A  (Fuji Photo Film Co., Ltd.),<br>25 March, 2004 (25.03.04),<br>Full text; all drawings<br>(Family: none) | 1-17 |

| ☒ | Further documents are listed in the continuation of Box C. | ☐ | See patent family annex. |

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 13 March, 2006 (13.03.06) | 20 March, 2006 (20.03.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

EP 1 840 978 A1

**INTERNATIONAL SEARCH REPORT**

International application No.

PCT/JP2006/300550

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2000-68553 A  (Anritsu Corp.),<br>03 March, 2000 (03.03.00),<br>Par. Nos. [0002] to [0009]; Fig. 10<br>(Family: none) | 1-17 |
| A | JP 2004-179428 A  (Rohm Co., Ltd.),<br>24 June, 2004 (24.06.04),<br>Full text; all drawings<br>(Family: none) | 1-17 |
| A | JP 2002-368342 A  (Anritsu Corp.),<br>20 December, 2002 (20.12.02),<br>Par. Nos. [0036] to [0039]; Fig. 8<br>(Family: none) | 1-17 |

Form PCT/ISA/210 (continuation of second sheet) (April 2005)